# EUROPEAN PATENT APPLICATION

(11) **EP 2 998 752 A1**
(43) Date of publication of application: **23.03.2016**
(21) Application number: 14275197.3
(22) Date of filing: 22.09.2014
(51) Int. Cl.: G01R 31/333, H02M 7/483

(54) **Synthetic test circuit**

(71) Applicant: ALSTOM Technology Ltd, 5400 Baden (CH)
(72) Inventor: TRAINER, David Reginald, Alvaston Derby, DE24 0AQ (GB); DANG, Si, Stafford, ST16 2EB (GB); MORENO MUÑOZ, Francisco Jose, Stafford, ST16 2QZ (GB)
(74) Representative: Potter Clarkson LLP

(57) **Abstract**

There is provided a synthetic test circuit (30), for performing an electrical test on a device under test, comprising:
a device under test including a chain-link converter (52) under test, the chain-link converter (52) under test including a test module or a plurality of test modules, the or each test module including at least one energy storage device;
a terminal (32,34) connected to the device under test;
at least one injection circuit (36,40) operably connected to the terminal (32,34), the or each injection circuit (36,40) including a source, the source including a source chain-link converter, the source chain-link converter including a plurality of source modules, each source module including at least one energy storage device;
a controller (50) being configured to operate each source module to selectively bypass the or each corresponding energy storage device and insert the or each corresponding energy storage device into the corresponding source chain-link converter so as to generate a voltage across the source chain-link converter and thereby operate the or each injection circuit (36,40) to inject a current waveform and/or a voltage waveform into the chain-link converter (52) under test.

## Description

This invention relates to a synthetic test circuit for performing an electrical test on a device under test, in particular a synthetic test circuit for performing an electrical test on a chain-link converter under test for use in high voltage direct current (HVDC) power transmission.

It is known to employ a synthetic test circuit to test an electrical component that is for use in HVDC power transmission. The term "synthetic" is used to describe the test circuit because the test circuit does not form part of an actual HVDC station converter, i.e. the electrical component under test is not connected into the actual HVDC station converter which transfers significant real power.

According to an aspect of the invention, there is provided a synthetic test circuit, for performing an electrical test on a device under test, comprising:
a device under test including a chain-link converter under test, the chain-link converter under test including a test module or a plurality of test modules, the or each test module including at least one energy storage device;
a terminal connected to the device under test;
at least one injection circuit operably connected to the terminal, the or each injection circuit including a source, the source including a source chain-link converter, the source chain-link converter including a plurality of source modules, each source module including at least one energy storage device;
a controller being configured to operate each source module to selectively bypass the or each corresponding energy storage device and insert the or each corresponding energy storage device into the corresponding source chain-link converter so as to generate a voltage across the source chain-link converter and thereby operate the or each injection circuit to inject a current waveform and/or a voltage waveform into the chain-link converter under test.

The structure of the chain-link converter (which may, for example, comprise a plurality of series-connected modules) permits build-up of a combined voltage across the chain-link converter, which is higher than the voltage available from each of its individual modules, via the insertion of the energy storage devices of multiple modules, each providing its own voltage, into the chain-link converter. In this manner the chain-link converter is capable of providing a stepped variable voltage source, which permits the generation of a voltage waveform across the chain-link converter using a step-wise approximation. As such the or each source chain-link converter is capable of providing complex voltage waveforms to enable the or each injection circuit to inject a wide range of current waveforms and/or voltage waveforms into the chain-link converter under test, and so enables the synthetic test circuit to readily and reliably create test current and/or voltage conditions that are identical or closely similar to actual in-service current and/or voltage conditions.

In addition the capability of the chain-link converter to generate a voltage waveform thereacross using a step-wise approximation allows the or each injection circuit to inject current waveforms and/or voltage waveforms of varying levels into the chain-link converter under test, and thus renders the synthetic test circuit capable of electrically testing various chain-link converters across a wide range of ratings.

Furthermore the modular arrangement of the chain-link converter means that the number of modules in the chain-link converter can be readily scaled up or down to modify the voltage capability of the or each source chain-link converter to match the testing requirements of the chain-link converter under test, without having to make significant changes to the overall design of the synthetic test circuit.

The provision of the source chain-link converter in the or each injection circuit therefore results in a synthetic test circuit that is not only capable of performing high quality electrical testing, but also has the flexibility to perform an electrical test on a broad range of chain-link converters with different ratings.

The structure of the or each injection circuit may vary to meet the testing requirements of the chain-link converter under test.

The or each source may include an inductor connected to the corresponding source chain-link converter. The inclusion of the inductor in the or each source provides a current control element for improving control over the injection of a current waveform into the chain-link converter under test.

The or at least one source module may include at least one module switch connected with the or each energy storage device to define a unipolar module that can provide zero or positive voltages. Optionally the or at least one source module may include a plurality of module switches connected in parallel with an energy storage device in a half-bridge arrangement to define a unipolar module that can provide zero or positive voltages. Further optionally the or at least one source module may include a plurality of module switches connected in parallel with an energy storage device in a half-bridge arrangement to define a 2-quadrant unipolar module that can provide zero or positive voltages and can conduct current in two directions.

The or at least one source module may include at least one module switch connected with the or each energy storage device to define a bipolar module that can provide negative, zero or positive voltages. Optionally the or at least one source module may include a plurality of module switches connected in parallel with an energy storage device in a full-bridge arrangement to define a bipolar module that can provide negative, zero or positive voltages. Further optionally the or at least one source module may include a plurality of module switches connected in parallel with an energy storage device in a full-bridge arrangement to define a 4-quadrant bipolar module that can provide negative, zero or positive voltages and can conduct current in two directions.

The or each injection circuit may include a plurality of parallel-connected sources. The number of parallel-connected sources in the or each injection circuit may vary to adapt the current capability of the or each injection circuit for compatibility with the current rating and test current conditions of the chain-link converter under test.

The or at least one injection circuit may be a current injection circuit. The current injection circuit may include a current source. The current source may include a source chain-link converter. The source chain-link converter may include a plurality of source modules.

The or at least one injection circuit may be a voltage injection circuit. The voltage injection circuit may include a voltage source. The voltage source may include a source chain-link converter. The source chain-link converter may include a plurality of source modules.

As mentioned above, the structure of the chain-link converter permits operation of the or each source chain-link converter to inject a wide range of current waveforms and/or voltage waveforms into the chain-link converter under test.

In embodiments of the invention, the current waveform injected into the chain-link converter under test may be selected from a group including:
- a part-sinusoidal or fully-sinusoidal current waveform;
- a harmonic modulated current waveform;
- a current waveform that includes one or more anti-phase current components, preferably a current waveform that includes one or more anti-phase harmonic or ripple components;
- a current waveform with a duty cycle of 180 or 240 electrical degrees;
- a bidirectional or unidirectional current waveform; or
- a combination thereof.

In further embodiments of the invention, the voltage waveform injected into the chain-link converter under test may be selected from a group including:
- a part-sinusoidal or fully-sinusoidal voltage waveform;
- a harmonic modulated voltage waveform, preferably a triplen harmonic modulated voltage waveform;
- a voltage waveform including voltage ripple;
- a voltage waveform with a duty cycle of 180 or 240 electrical degrees;
- a bidirectional or unidirectional voltage waveform; or
- a combination thereof.

In still further embodiments of the invention, the controller may be configured to operate the or each injection circuit to inject the current waveform into the chain-link converter under test so as to control an energy level of the or each energy storage device of the or each test module and/or control the energy level of the chain-link converter under test to obtain a zero net change in energy level of the chain-link converter under test over an operating cycle. This permits electrical testing of the capability of the chain-link converter under test to control its energy level and/or the energy level of the or each corresponding energy storage device.

In a similar fashion to that of the or each injection circuit, the structure of the chain-link converter enables the chain-link converter under test to be operated to generate a wide range of voltage waveforms thereacross. More specifically, the controller may be configured to operate the or each test module to selectively bypass the or each corresponding energy storage device and insert the or each corresponding energy storage device into the chain-link converter under test so as to generate a voltage waveform across the chain-link converter under test during the injection of the current waveform and/or the voltage waveform into the chain-link converter under test. The ability to operate the chain-link converter under test to generate a voltage waveform thereacross during the injection of the current waveform and/or the voltage waveform into the chain-link converter under test provides further options for electrical testing of the operational capabilities of the chain-link converter under test, thus enhancing the electrical testing capabilities of the synthetic test circuit.

Examples of further options for testing the operational capabilities of the chain-link converter under test are described as follows.

In embodiments of the invention, the voltage waveform across the chain-link converter under test may be selected from a group including:
- a part-sinusoidal or fully-sinusoidal voltage waveform;
- a harmonic modulated voltage waveform, preferably a triplen harmonic modulated voltage waveform;
- a voltage waveform including voltage ripple;
- a voltage waveform with a period of 180 or 240 electrical degrees;
- a bidirectional or unidirectional voltage waveform; or
- a combination thereof.

In further embodiments of the invention, the controller may be configured to operate the or each test module to selectively bypass the or each corresponding energy storage device and insert the or each corresponding energy storage device into the chain-link converter under test so as to generate a voltage waveform across the chain-link converter under test during the injection of the current waveform and/or the voltage waveform into the chain-link converter under test so as to:
- combine the voltages across the or each source chain-link converter and the chain-link converter under test and thereby control the current waveform injected into the chain-link converter under test;
- control an energy level of the or each energy storage device of the or each test module;
- control the energy level of the chain-link converter under test to obtain a zero net change in energy level of the chain-link converter under test over an operating cycle;
- control the energy level of the chain-link converter under test to obtain a zero net change in energy level of the or each test module over an operating cycle;
- when the chain-link converter includes a plurality of test modules, equalise or substantially equalise the voltage levels of the plurality of test modules;
- control the current loading of the or each test module;
- when the chain-link converter includes a plurality of test modules, equalise or substantially equalise the current loading of the plurality of test modules; and/or
- control the injected current waveform to be a leading current, a lagging current, or in-phase with the voltage waveform across the chain-link converter under test.

In still further embodiments of the invention, the or each test module may include at least one module switch, and the controller is configured to control switching of the or each module switch of the or each test module to selectively bypass the or each corresponding energy storage device and insert the or each corresponding energy storage device into the chain-link converter under test so as to generate a voltage waveform across the chain-link converter under test.

This permits testing of the switching capabilities of the or each module switch of the or each test module. For example, the controller may be configured to control switching of the or each module switch of the or each test module so as to switch at a peak, non-zero, zero or substantially zero value of the current waveform injected into the chain-link converter under test and/or at a peak or non-zero value of the voltage waveform injected into the chain-link converter under test.

Optionally the controller may be configured to control switching of the or each module switch of the or each test module so as to block current from flowing in the or each test module and thereby inhibit current from flowing in the chain-link converter under test. This permits electrical testing of the chain-link converter under test in its non-conducting state.

The or each module switch of the or each test module may include an active switching device connected in parallel with an anti-parallel passive current check element. In this case the controller may be configured to turn off the or each active switching device of the or each test module to allow the anti-parallel passive current check elements to form a plurality of series-connected passive current check element rectifiers with a combined internal voltage that is greater than a voltage waveform across the chain-link converter under test so as to block current from flowing in the or each test module and thereby inhibit current from flowing in the chain-link converter under test, wherein the combined internal voltage is provided by the or each energy storage device of the or each test module.

For the purposes of this specification, a current check element is a device that permits current to flow therethrough in only one direction, e.g. a diode.

The controller may be configured to operate the or each injection circuit to inject a voltage waveform into the chain-link converter under test when the chain-link converter under test is controlled to inhibit current from flowing in the chain-link converter under test. This permits voltage testing of the chain-link converter under test in its non-conducting state. For example, the controller may be configured to operate the or each injection circuit to control the magnitude, shape, rate of change and/or duration of the voltage waveform injected into the chain-link converter under test that is controlled to inhibit current from flowing therethrough.

In embodiments of the invention the controller may be configured to operate the or each injection circuit to inject an overcurrent waveform into the chain-link converter under test and to control the chain-link converter under test to inhibit the overcurrent waveform from flowing in the chain-link converter under test. For the purposes of this specification, an overcurrent waveform is intended to refer to a current waveform with a magnitude that exceeds the current rating of the chain-link converter under test.

The configuration of the controller in this manner permits electrical testing of the chain-link converter under test in overcurrent conditions, examples of which are described as follows.

The electrical test may involve simulation of DC fault current extinction with both polarities of an alternating driving voltage. Such an electrical test may be performed by, for example, configuring the controller to operate the or each injection circuit to inject an alternating voltage waveform into the chain-link converter under test when the overcurrent waveform is inhibited from flowing in the chain-link converter under test.

The electrical test may involve simulation of the operation of the chain-link converter under test in a static synchronous compensator during a DC fault. Such an electrical test may be performed by, for example, configuring the controller to operate the or each injection circuit to:
- inject a first alternating voltage waveform into the chain-link converter under test; and
- operate the or each test module to selectively bypass the or each corresponding energy storage device and insert the or each corresponding energy storage device into the chain-link converter under test so as to generate a second alternating voltage waveform across the chain-link converter under test,
subsequent to the overcurrent waveform being inhibited from flowing in the chain-link converter under test.

Preferred embodiments of the invention will now be described, by way of non-limiting examples, with reference to the accompanying drawings in which:
Figures 1 a and 1 b show schematically a synthetic test circuit according to a first embodiment of the invention;
Figures 2a and 2b show schematically the structures of the 4-quadrant bipolar module and 2-quadrant unipolar module respectively;
Figures 3 and 4 illustrate the basic operations of the current and voltage injection circuits of Figures 1a and 1b;
Figure 5 shows schematically an example of a voltage source converter for use in HVDC power transmission;
Figure 6 illustrates the operation of the current injection circuit of Figure 1 a to inject both voltage and current waveforms into a chain-link converter under test;
Figure 7 illustrates a first example of actual in-service current and voltage conditions experienced by a chain-link converter in an Alternate Arm Converter;
Figure 8 illustrates the operation of the synthetic test circuit of Figure 1a to create test current and voltage conditions corresponding to the actual in-service current and voltage conditions of Figure 7;
Figure 9 shows the results of a simulation model of the operation of the synthetic test circuit illustrated in Figure 8;
Figure 10 illustrates a second example of actual in-service current and voltage conditions experienced by a chain-link converter in an Alternate Arm Converter;
Figure 11 shows the results of a simulation model of the operation of the synthetic test circuit of Figure 1 a to create test current and voltage conditions corresponding to the actual in-service current and voltage conditions of Figure 10;
Figure 12 illustrates the operation of a chain-link converter to control the energy level of the chain-link converter to obtain a zero net change in energy level of the chain-link converter over an operating cycle;
Figure 13 illustrates the operation of a chain-link converter to enable voltage balancing of the modules of the chain-link converter;
Figure 14 illustrates the operation of the synthetic test circuit of Figure 1 a to create test current and voltage conditions corresponding to the actual in-service current and voltage conditions that relate to actual in-service reactive power conditions;
Figure 15 shows the results of a simulation model of the operation of the synthetic test circuit to create test current and voltage conditions shown in Figure 14;
Figure 16 shows exemplary voltage waveforms that may be injected into a chain-link converter under test when the chain-link converter under test is in a non-conducting state;
Figures 17 and 18 illustrate the operation of the synthetic test circuit of Figure 1 a to create test current and voltage conditions corresponding to the actual in-service current and voltage conditions during a DC fault; and
Figure 19 shows schematically a synthetic test circuit according to a second embodiment of the invention.

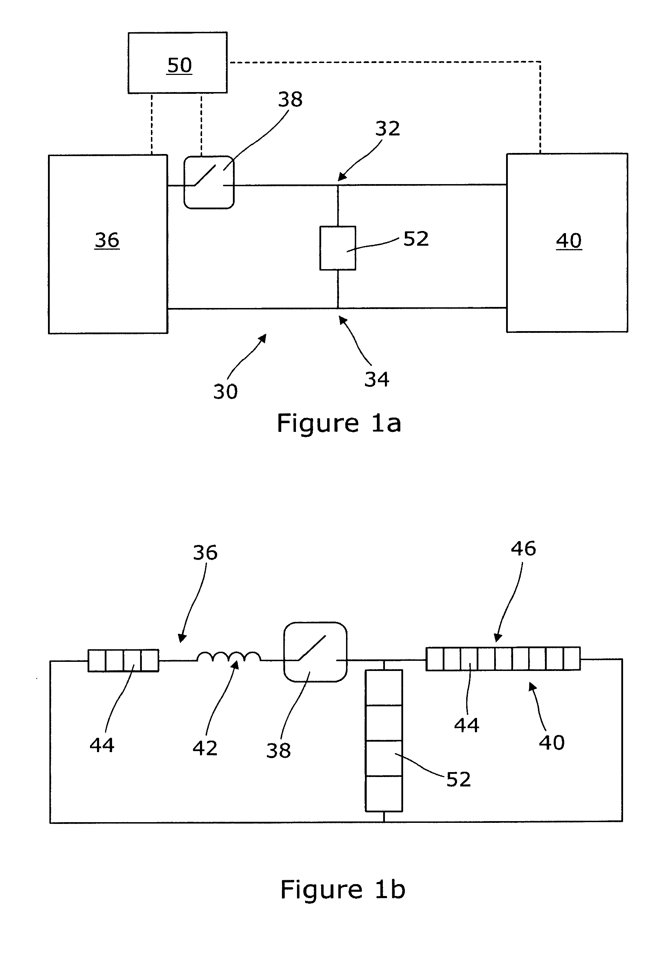

A synthetic test circuit according to a first embodiment of the invention is shown in Figures 1 a and 1 b, and is designated generally by the reference numeral 30.

The synthetic test circuit 30 comprises first and second terminals 32,34, a current injection circuit 36, an isolation switch 38 and a voltage injection circuit 40. As shown in Figures 1 a and 1 b, the current injection circuit 36 is connected in series with the isolation switch 38 between the first and second terminals 32,34, and the voltage injection circuit 40 is connected between the first and second terminals 32,34, and is thereby connected in parallel with the series connection of the current injection circuit 36 and isolation switch 38.

The current injection circuit 36 includes a current source. The current source includes a series connection of an inductor 42 and a source chain-link converter 44.

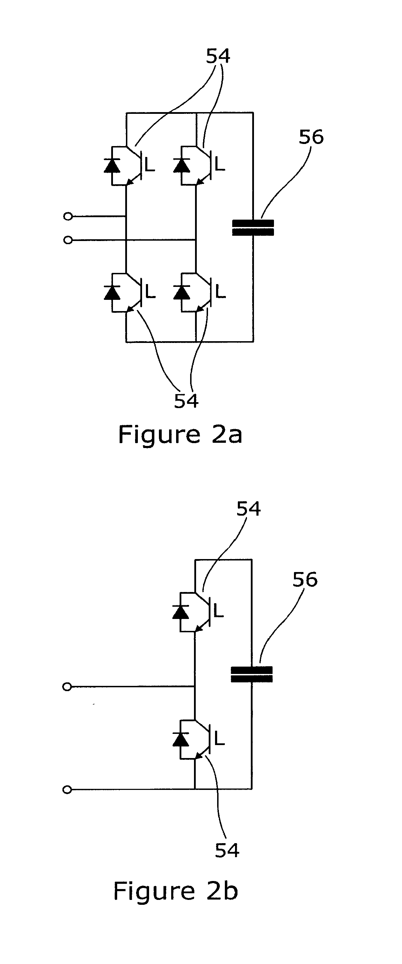

The source chain-link converter 44 of the current injection circuit includes a plurality of series-connected source modules. Each source module includes two pairs of module switches 54 and an energy storage device in the form of a capacitor 56. In each source module, the pairs of module switches 54 are connected in parallel with the capacitor 56 in a full-bridge arrangement to define a 4-quadrant bipolar module that can provide negative, zero or positive voltages and can conduct current in two directions. Figure 2a shows the structure of the 4-quadrant bipolar module.

The capacitor 56 of each source module of the current injection circuit is selectively bypassed and inserted into the source chain-link converter 44 by changing the states of the corresponding module switches 54. This selectively directs current through the capacitor 56 or causes current to bypass the capacitor 56 so that the source module provides a negative, zero or positive voltage.

The capacitor 56 of the source module is bypassed when the module switches 54 are configured to form a current path that causes current in the respective source chain-link converter 44 to bypass the capacitor 56, and so the source module provides a zero voltage, i.e. the source module is configured in a bypassed mode.

The capacitor 56 of the source module is inserted into the respective source chain-link converter 44 when the module switches 54 are configured to allow the current in the respective source chain-link converter 44 to flow into and out of the capacitor 56. The capacitor 56 then charges or discharges its stored energy so as to provide a non-zero voltage, i.e. the source module is configured in a non-bypassed mode. The full-bridge arrangement of the module switches permits configuration of the module switches 54 to cause current to flow into and out of the capacitor 56 in either direction, and so each source module can be configured to provide a negative or positive voltage in the non-bypassed mode.

The voltage injection circuit 40 includes a voltage source 46. The voltage source 46 includes a source chain-link converter 44, the structure and operation of which is identical to that of the source chain-link converter of the current source of the current injection circuit 36. The voltage source converter further includes an inductor (not shown) connected in series with the source chain-link converter 44.

The structure of each source chain-link converter 44 permits build-up of a combined voltage across each source chain-link converter 44, which is higher than the voltage available from each of its individual source modules, via the insertion of the capacitors 56 of multiple source modules, each providing its own voltage, into each source chain-link converter 44. In this manner each source chain-link converter 44 is capable of providing a stepped variable voltage source, which permits the generation of a voltage waveform across each source chain-link converter 44 using a step-wise approximation. As such each source chain-link converter 44 is capable of providing complex voltage waveforms.

Each module switch 54 constitutes an insulated gate bipolar transistor (IGBT) that is connected in anti-parallel with a diode. It is envisaged that, in other embodiments of the invention, each IGBT may be replaced by a gate turn-off thyristor, a field effect transistor, an injection-enhanced gate transistor, an integrated gate commutated thyristor or any other self-commutated switching device.

It is envisaged that, in other embodiments of the invention, each capacitor 56 may be replaced by another type of energy storage device that is capable of storing and releasing energy, e.g. a battery or fuel cell.

It is also envisaged that, in other embodiments of the invention, each of the current and voltage injection circuits 36,40 may include a different number and/or arrangement of chain-link converters 44.

The controller 50 is configured to control switching of the module switches 54 of each source module to selectively bypass the corresponding capacitor 56 and insert the corresponding capacitor 56 into the corresponding source chain-link converter 44 so as to generate a voltage across the corresponding source chain-link converter 44.

The controller 50 is further configured to control switching of the isolation switch 38 to switch the current injection circuit 36 into and out of circuit with the first and second terminals 32,34 so as to selectively isolate the current injection circuit 36 from the device under test and the voltage injection circuit 40. The provision of the isolation switch 38 permits the current injection circuit 36 to be configured as a low voltage, high current injection circuit 36, and the voltage injection circuit 40 to be configured as a low current, high voltage injection circuit 40.

In use a chain-link converter 52 under test is connected between the first and second terminals 32,34.

The structure and operation of the chain-link converter 52 under test is identical to that of each of the aforementioned source chain-link converters. More specifically, the chain-link converter 52 under test includes a plurality of test modules, and the structure and operation of each test module is identical to that of each source module.

The controller 50 is configured to control switching of the module switches 54 of each test module to selectively bypass the corresponding capacitor 56 and insert the corresponding capacitor 56 into the chain-link converter 52 under test so as to generate a voltage across the corresponding chain-link converter 52 under test.

It will be appreciated that the number of modules in each chain-link converter 44,52 may vary depending on their respective requirements.

It is envisaged that, in other embodiments of the invention, each module may be replaced by another module with a different configuration. For example, each module may include a pairs of module switches 54 and an energy storage device in the form of a capacitor 56, the pair of module switches 54 are connected in parallel with the capacitor 56 in a half-bridge arrangement to define a 2-quadrant unipolar module that can provide zero or positive voltages and can conduct current in two directions. Figure 2b shows the structure of the 2-quadrant unipolar module.

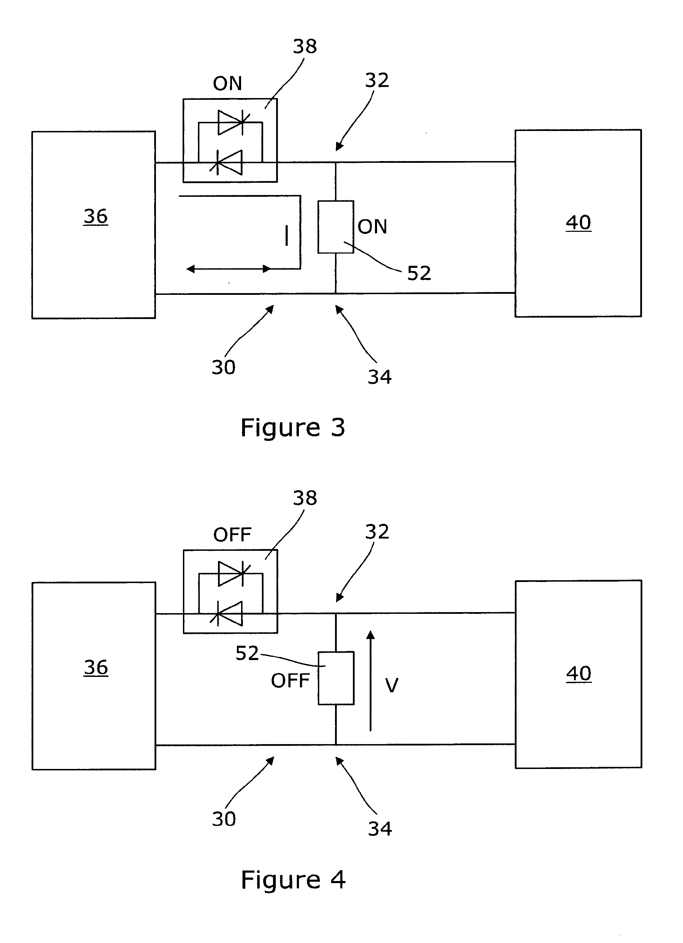

The configuration of the synthetic test circuit 30 as set out above enables the current injection circuit 36 to be operated to inject a current waveform I into the chain-link converter 52 under test, as shown in Figure 3, and enables the voltage injection circuit 40 to be operated to inject a voltage waveform V into the chain-link converter 52 under test, as shown in Figure 4. A cycle of such injections of current and voltage waveforms may be repeated at a desired frequency (e.g. 50 Hz).

Preferably, the isolation switch 38 is closed when the current injection circuit 36 is operated to inject the current waveform I into the chain-link converter 52 under test, and the isolation switch 38 is opened when the voltage injection circuit 40 is operated to inject the voltage waveform V into the chain-link converter 52 under test. Also preferably, when the chain-link converter 52 under test is conducting a positive or negative current injected by the current injection circuit, the controller 50 controls the switching of the module switches 54 of the voltage injection circuit 40 so as to block current from flowing through the voltage injection circuit 40 and thereby prevent the modules of the voltage injection circuit 40 from discharging into the chain-link converter 52 under test. This means that the synthetic test circuit 30 would not be required to supply high voltage and high current at the same time, thus minimising the amount of power used during electrical testing of the chain-link converter 52.

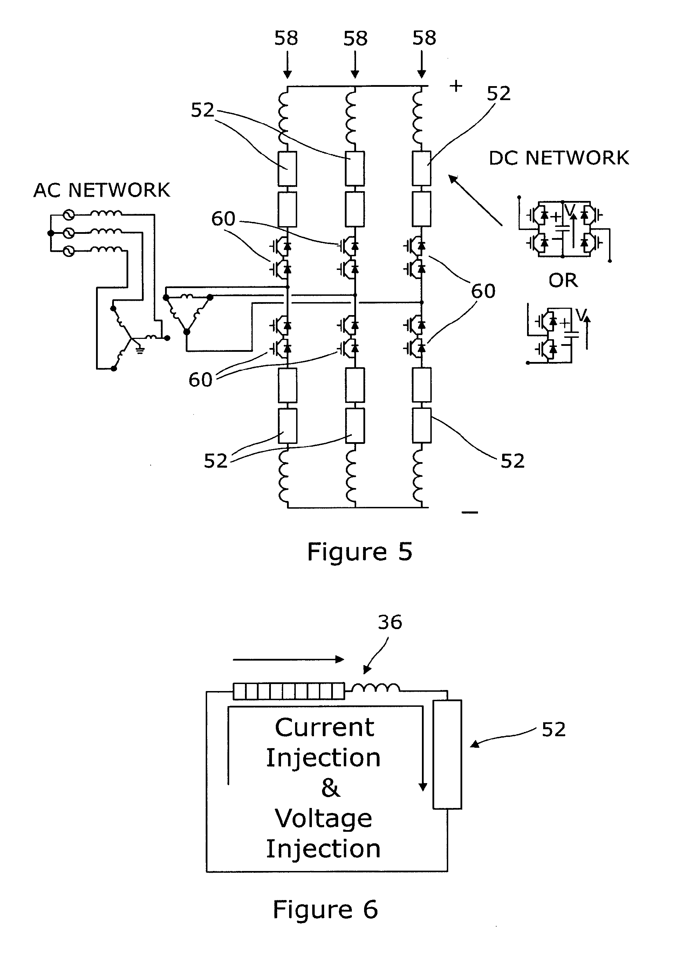

Figure 5 show, in schematic form, an exemplary application of the chain-link converter 52 for use in HVDC power transmission.

In the exemplary application, the chain-link converter 52 forms part of an Alternate Arm Converter (AAC). The AAC includes a plurality of converter limbs 58, each of which extends between first and second DC terminals and includes first and second limb portions separated by a respective AC terminal. Each limb portion includes a chain-link converter 52 connected in series with a director switch 60. Each chain-link converter 52 includes a plurality of series-connected modules, each of which may be in the form of a 4-quadrant bipolar module or a 2-quadrant unipolar module. In use, each limb portion is operable to switch the corresponding limb portion into and out of circuit between the corresponding AC and DC terminals.

During such switching of each limb portion of the AAC, each limb portion starts and ends conduction at zero current on a repetition cycle, typically at a frequency of 50 Hz. Whilst each limb portion starts and ends conduction at zero current, each module of the chain-link converter 52 is switched in and out of circuit to generate a sinusoidal voltage waveform at the respective AC terminal. The IGBTs and diodes within each module are switched on and off, with each IGBT and diode experiencing hard voltage commutation at the capacitor voltage (which is typically 2 kV). The IGBTs and diodes switch on and off at different times and thus can switch at a current flowing in the corresponding limb portion ranging from zero current to a peak current value, e.g. 1500 A.

To enable voltage balancing of the modules within each limb portion, the capacitor 56 of each module is selectively bypassed and inserted into the corresponding chain-link converter such that each module and module switch 54 experience low current and high current switching in set amounts of time.

To enable DC filtering, the capacitor 56 of each module is selectively bypassed and inserted into the corresponding chain-link converter 52 so as to filter one or more harmonic or ripple components from a current waveform flowing therethrough.

The chain-link converter 52 and its components therefore experiences a wide range of actual in-service current and voltage conditions during its use in the AAC arrangement.

Typically the chain-link converter 52 must comply with various testing requirements, which are identical or closely similar to actual in-service current and voltage conditions, in order to be certified for service operation.

Therefore, in order to check whether the chain-link converter 52 complies with such testing requirements, the synthetic test circuit 30 is controlled to perform an electrical test on the chain-link converter 52 that involves creation of test conditions including one or more of, but are not limited to:
- sinusoidal current and voltage waveforms representative of actual in-service operation;
- operation of the chain-link converter 52 under test to generate sinusoidal and triplen harmonic modulated voltage waveforms;
- current and voltage waveforms representative of hard voltage and hard current switching of each module switch 54 of each test module at varying levels up to peak current rating;
- operation of the chain-link converter 52 under test to generate voltage waveforms with duty cycles of 180 and 240 electrical degrees and to conduct a current waveform with duty cycles of 180 and 240 electrical degrees;
- a current waveform that includes one or more anti-phase harmonic or ripple components;
- control over the overall energy level of the chain-link converter 52 under test and the individual energy levels of the test modules;
- control over the thermal loading of the test modules;
- current and voltage waveforms representative of actual in-service rectifier, inverter and leading/lagging reactive power operations;
- current and voltage waveforms representative of actual in-service current and voltage conditions of the chain-link converter 52 under DC fault conditions.

The capability of each chain-link converter 44,52 to provide complex voltage waveforms thereacross enables the current and voltage injection circuits 36,40 to inject a wide range of current and voltage waveforms into the chain-link converter 52 under test and enables the chain-link converter 52 under test to generate a wide range of voltage waveforms thereacross, and so enables the synthetic test circuit 30 to readily and reliably create test current and voltage conditions that are identical or closely similar to the above actual in-service current and voltage conditions.

It will be appreciated that the current and voltage waveforms in the figures are shown as continuous waveforms, but are actually stepwise approximated waveforms as constructed by the synthetic test circuit 30.

Figure 6 illustrates the operation of the current injection circuit 36 to inject both voltage and current waveforms into the chain-link converter 52 under test.

In particular, the controller 50 operates the current injection circuit 36 to inject both voltage and current waveforms into the chain-link converter 52 under test so as to perform at least one cycle of sequential injections of the voltage and current waveforms into the chain-link converter 52 under test. Meanwhile the voltage injection circuit 40 is operated to block current from flowing therethrough.

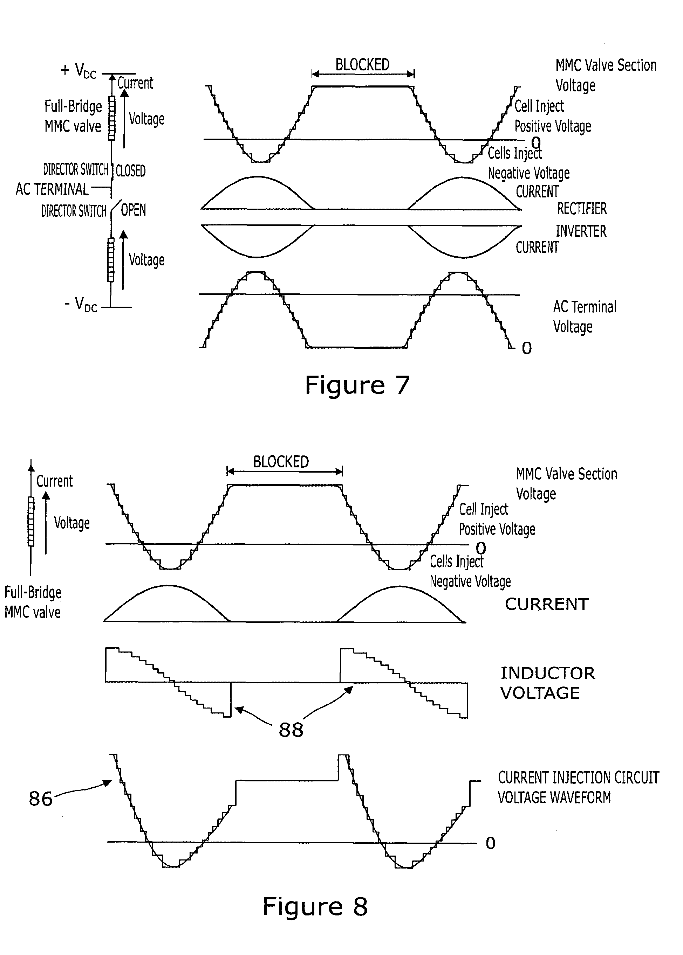

Figure 7 illustrates the actual in-service voltage and current conditions experienced by the chain-link converter 52 in both inverter and rectifier modes of the AAC arrangement, and their relationship to a sinusoidal voltage waveform formed at the AC terminal of the AAC arrangement. The actual in-service voltage and current conditions in Figure 7 relate to the positive half-cycle of the sinusoidal voltage waveform at the AC terminal of the AAC arrangement, but it will be understood that the chain-link converter 52 experiences similar actual in-service voltage and current conditions in relation to the negative half-cycle of the sinusoidal voltage waveform at the AC terminal of the AAC arrangement.

In order to create test current and voltage conditions that are identical or closely similar to the actual in-service current and voltage conditions shown in Figure 7, the current injection circuit 36 is operated to generate a bidirectional voltage waveform across the corresponding source chain-link converter 44. Meanwhile the chain-link converter 52 under test is operated to generate a bidirectional voltage waveform thereacross, whereby the generated bidirectional voltage waveform across the chain-link converter 52 under test is identical or closely similar to the actual in-service voltage conditions experienced by the chain-link converter shown in Figure 7.

The voltages 86 across the source chain-link converter 44 and the chain-link converter 52 under test combine to control the voltage 88 across the inductor 42 and thereby control the current waveform injected into the chain-link converter 52 under test. Hence, in order to provide the voltage 88 across the inductor 42 to inject the current waveform into the chain-link converter 52 under test, the source chain-link converter 44 of the current injection circuit 36 is operated to generate a voltage waveform 86 thereacross that is the sum of the voltage 88 across the inductor and the voltage across the chain-link converter 52 under test, as shown in Figure 8.

To create test current conditions that are identical or closely similar to the actual in-service current conditions in the rectifier mode of the AAC arrangement, the voltage across the inductor 42 is controlled to have a zero average component and to start with a positive section and end with a negative section so as to control the direction of current injected into the chain-link converter 52 under test, as shown in Figure 8.

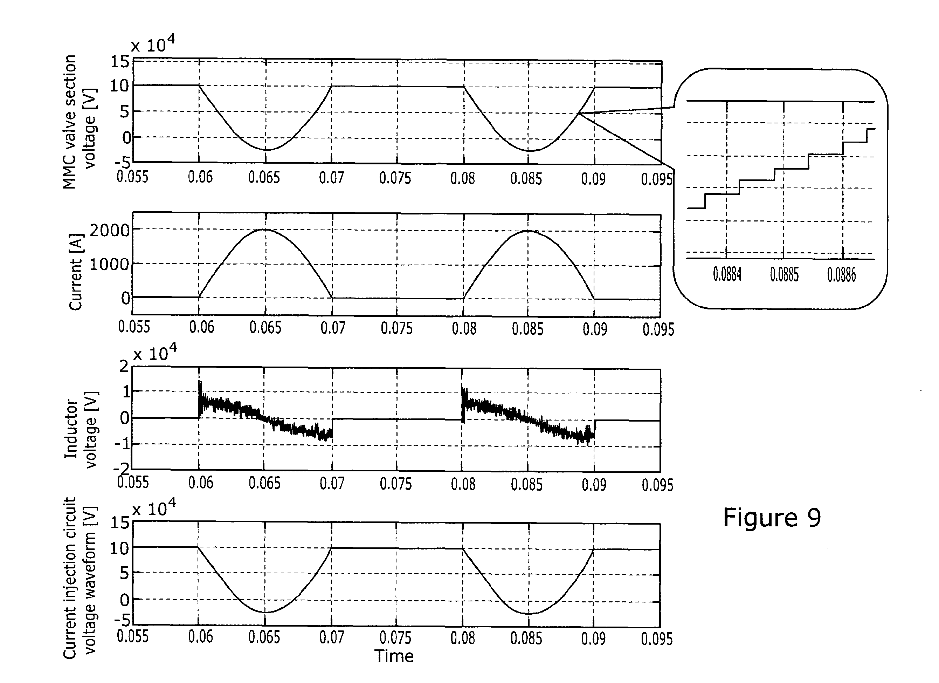

Figure 9 shows the results of a simulation model of the operation of the synthetic test circuit 30 to create test current and voltage conditions that are identical or closely similar to the actual in-service current and voltage conditions in the rectifier mode of the AAC arrangement. It can be seen from Figure 9 that the simulated test current and voltage conditions are comparable to the target test current and voltage conditions shown in Figure 8, and so it follows the synthetic test circuit 30 is capable of creating test current and voltage conditions that are identical or closely similar to the actual in-service current and voltage conditions in the rectifier mode of the AAC arrangement.

Similarly, to create test current conditions that are identical or closely similar to the actual in-service current conditions in the inverter mode of the AAC arrangement, the voltage across the inductor 42 is controlled to have a zero average component and to start with a negative section and end with a positive section so as to control the direction of current injected into the chain-link converter 52 under test.

The operation of the synthetic test circuit 30 described with reference to Figures 7 and 8 are also applicable to electrical testing of the chain-link converter 52 under test on the basis of other complex waveforms, examples of which are described as follows.

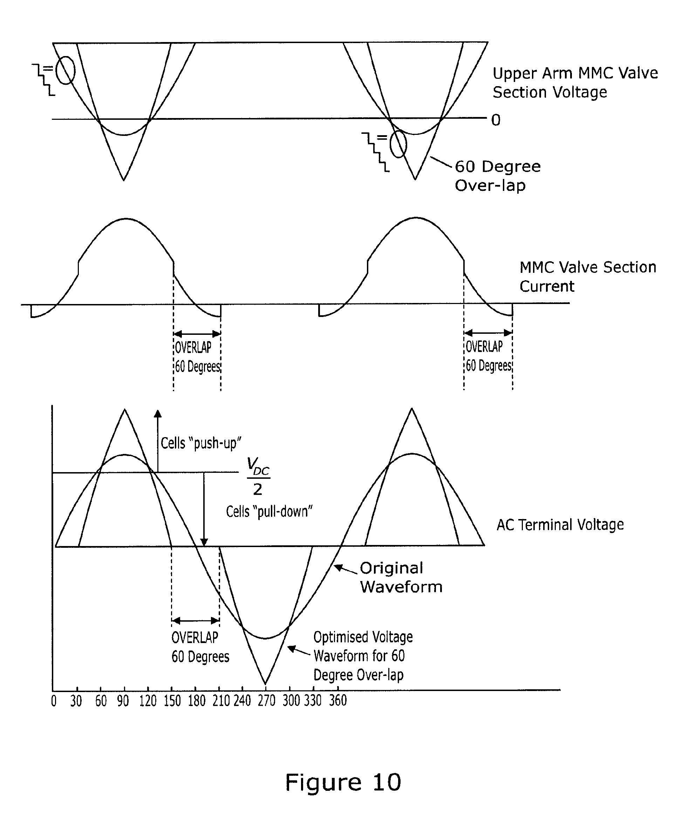

In use, each chain-link converter 52 of the AAC arrangement may be required to track a triplen harmonic modulated voltage waveform, i.e. a voltage waveform that includes one or more triplen (3^{rd}, 9^{th}, 15^{tn},) harmonic components which are zero-phase sequence in nature. Figure 10 shows an exemplary triplen harmonic modulated voltage waveform generated across a chain-link converter 52, whereby the voltage waveform includes a 3^{rd} harmonic component. Accordingly, during use of the synthetic test circuit 30 to perform an electrical test of the chain-link converter 52 under test, the chain-link converter 52 may be operated to generate the triplen harmonic modulated voltage waveform thereacross whilst the current injection circuit 36 is operated to inject a current waveform into the chain-link converter 52 under test.

In use, each chain-link converter 52 of the AAC arrangement may be required to filter one or more harmonic or ripple components from a current waveform flowing therethrough. A consequence of this filtering process is that the current flowing through each chain-link converter 52 changes from a half-cycle sinusoid to a more complex waveform, as shown in Figure 10. The filtering process may require a conduction overlap, e.g. a 60 electrical degrees overlap, between the limb portions of the AAC arrangement, whereby both limb portions are in simultaneous conduction to form a circulation path that includes the DC network and the limb portions. Such a conduction overlap requires the conduction of each limb portion to be extended above the 180 electrical degrees duty cycle associated with the half-cycle sinusoid, e.g. to 240 electrical degrees to achieve a 60 electrical degrees conduction overlap, as shown in Figure 10.

Accordingly, during use of the synthetic test circuit 30 to perform an electrical test of the chain-link converter 52 under test, the current injection circuit 36 is operated to inject a bidirectional current waveform into the chain-link converter 52 under test. The bidirectional current waveform has a duty cycle of 240 electrical degrees, unlike a half-cycle sinusoid that has a duty cycle of 180 electrical degrees, and includes sections of an anti-phase 6^{th} harmonic ripple current to simulate the aforementioned filtering process. More specifically, the bidirectional current waveform injected into the chain-link converter 52 under test begins with a negative, first current portion, continues with a positive, second current portion, and ends with a negative, third current portion. Meanwhile the chain-link converter 52 under test is operated to generate a voltage waveform thereacross, whereby the shape of the voltage waveform permits the formation of the conduction overlap.

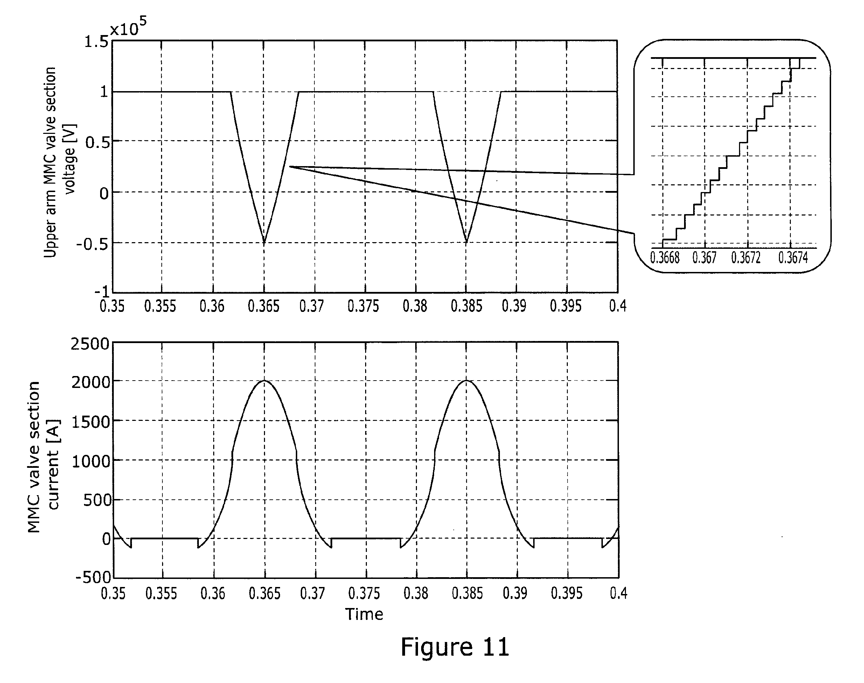

Figure 11 illustrates the results of a simulation model of the operation of the synthetic test circuit 30 to create test current and voltage conditions that are identical or closely similar to the actual in-service current and voltage conditions in Figure 10. It can be seen from Figure 11 that the simulated test current and voltage conditions are comparable to the target test current and voltage conditions shown in Figure 10, and so it follows the synthetic test circuit 30 is capable of creating test current and voltage conditions that are identical or closely similar to the actual in-service current and voltage conditions in which the chain-link converter 52 tracks a triplen harmonic modulated voltage waveform and performs the filtering process.

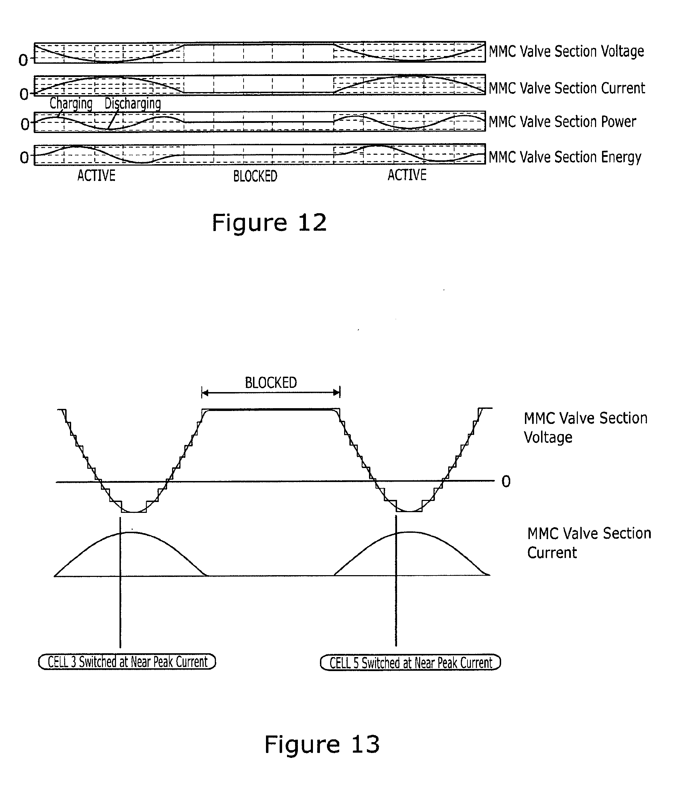

Figure 12 shows the operation of a chain-link converter 52 in which the voltage across the chain-link converter 52 and the current flowing through the chain-link converter 52 combine to control the energy level of the chain-link converter 52 to obtain a zero net change in energy level of the chain-link converter 52 over an operating cycle.

Accordingly, during use of the synthetic test circuit 30 to perform an electrical test of the chain-link converter 52 under test, the chain-link converter 52 under test is operated to generate a sinusoidal voltage waveform (or any other preferred voltage waveform) thereacross, while the current injection circuit 36 is operated to inject a current waveform into the chain-link converter 52 under test, whereby the current waveform is shaped to obtain a zero net change in energy level of the chain-link converter 52 over an operating cycle.

Figure 13 illustrates the operation of a chain-link converter 52 to enable voltage balancing of the modules of the chain-link converter 52. In use, whilst the chain-link converter 52 is operated to generate a voltage waveform thereacross, the capacitor 56 of each module is selectively bypassed and inserted into the chain-link converter 52 such that each module experience low current and high current switching in set amounts of time required to balance the voltage levels of the capacitors 56 of the modules. The full-bridge arrangement of each module enables each module to be charged and discharged in equal amounts whilst being inserted into the chain-link converter 52, and so it becomes possible to operate the chain-link converter 52 to selectively bypass and insert each capacitor 56 into the chain-link converter 52 in order to control the energy level of the chain-link converter 52 to obtain a zero net change in energy level of each module over an operating cycle.

Accordingly, during use of the synthetic test circuit 30 to perform an electrical test of the chain-link converter 52 under test, the current injection circuit 36 is operated to inject a current waveform into the chain-link converter 52 under test, and the chain-link converter 52 under test is operated to generate a voltage waveform thereacross and to selectively bypass and insert each capacitor 56 into the chain-link converter 52 under test so as to enable voltage balancing of the test modules and to control the energy level of the chain-link converter 52 under test to obtain a zero net change in energy level of each test module over an operating cycle.

In addition, during use of the synthetic test circuit 30 to perform an electrical test of the chain-link converter 52 under test, the chain-link converter 52 under test can be operated to selectively bypass and insert each capacitor 56 into the chain-link converter 52 under test to equalise the current loading of the test modules.

In use, the Alternate Arm Converter may operate over a wide active real power-reactive power (P-Q) operating envelope. As such the chain-link converter 52 must be capable of operating with not only a wide range of real power flows but also a wide range of reactive power flows.

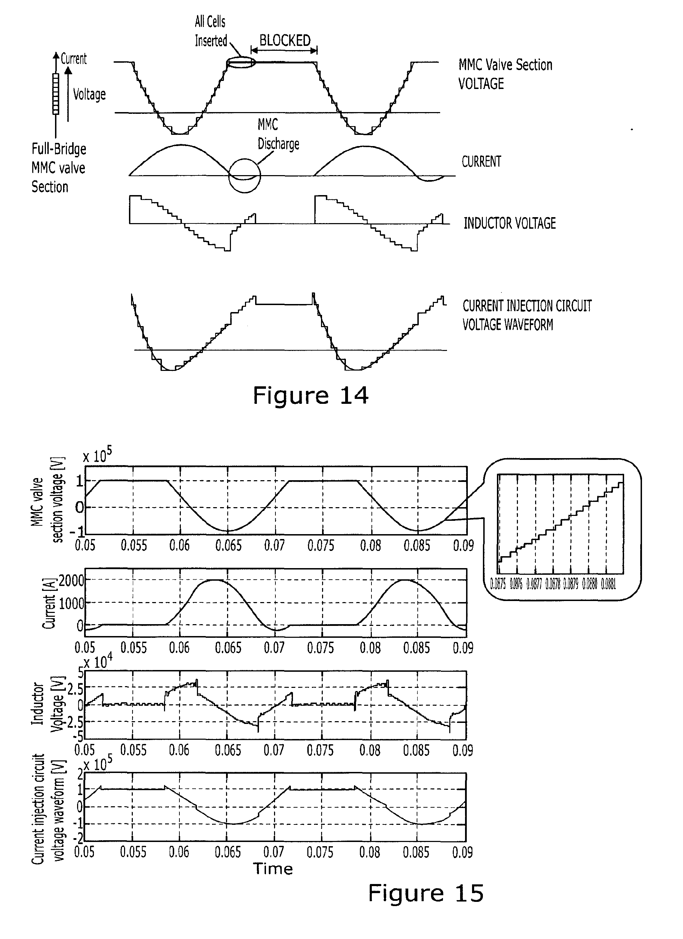

Accordingly, during use of the synthetic test circuit 30 to perform an electrical test of the chain-link converter 52 under test, the current injection circuit 36 is operated to generate a bidirectional voltage waveform across the corresponding source chain-link converter 44, while the chain-link converter 52 under test is operated to generate a bidirectional voltage waveform thereacross. The voltages across the source chain-link converter 44 and the chain-link converter 52 under test combine to control the voltage across the inductor 42 and thereby control the current waveform injected into the chain-link converter 52 under test, as shown in Figure 14. The injected current waveform may be controlled to be a leading current or a lagging current to create test reactive power conditions.

When the injected current waveform is a leading or lagging current, the injected current waveform may be controlled to further include an additional current pulse at the end of the operating cycle to charge or discharge the chain-link converter 52 under test so as to control the energy level of the chain-link converter 52 under test. Figure 14 shows the inclusion of an additional pulse in the injected current waveform to effect discharging of the chain-link converter 52 under test.

Figure 15 shows the results of a simulation model of the operation of the synthetic test circuit 30 to create test current and voltage conditions shown in Figure 14. It can be seen from Figure 15 that the simulated test current and voltage conditions are comparable to the target test current and voltage conditions shown in Figure 14, and so it follows the synthetic test circuit 30 is capable of creating test current and voltage conditions that are identical or closely similar to the actual in-service current and voltage conditions relating to actual in-service reactive power conditions.

In use, the chain-link converter 52 of the AAC arrangement may be operated to change from a conducting state to a non-conducting state. This is achieved by turning off each IGBT of each module to allow the anti-parallel diodes to form a plurality of series-connected diode rectifiers with a combined internal voltage that is greater than a voltage waveform across the chain-link converter 52 under test so as to block current from flowing in the module and thereby inhibit current from flowing in the chain-link converter 52 under test, wherein the combined internal voltage is provided by the capacitor 56 of each module.

Accordingly, during use of the synthetic test circuit 30 to perform an electrical test of the chain-link converter 52 under test, the chain-link converter 52 under test is operated to configure its test modules to form the plurality of series-connected diode rectifiers in order to block current from flowing therethrough and thereby inhibit current from flowing in the chain-link converter 52 under test.

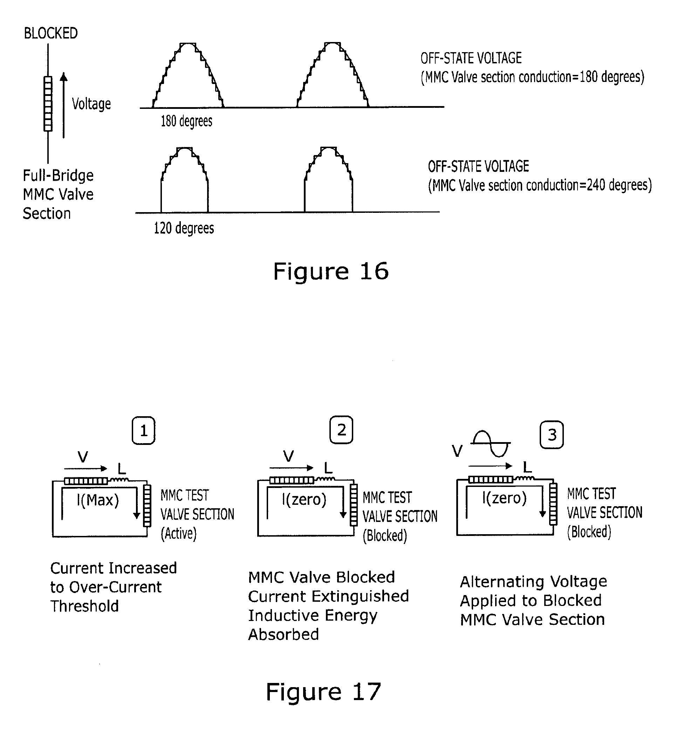

When the plurality of series-connected diode rectifiers is formed, the voltage injection circuit 40 can be controlled to inject a voltage waveform into the chain-link converter 52 under test. This permits voltage testing of the chain-link converter 52 under test in its non-conducting state. For example, the voltage injection circuit 40 may be operated to control the magnitude, shape, rate of change and/or duration of the voltage waveform injected into the chain-link converter 52 under test that is being controlled to inhibit current from flowing therethrough. Figure 16 shows exemplary voltage waveforms that may be injected into the chain-link converter 52 under test.

In use, a DC fault may occur in the DC network connected to the AAC. The occurrence of the DC fault may result in a high fault current flowing from the AC network to the DC network via the AAC, thus exposing the components of the AAC to the risk of damage.

When the DC fault occurs in the DC network, the chain-link converter 52 of the AAC arrangement may be operated to provide an opposing voltage to the fault current flowing through the AAC and thereby reduce the fault current to zero. In doing so the chain-link converter 52 is also required to absorb any inductive energy stored in the inductance of the AC network.

Accordingly, during use of the synthetic test circuit 30 to perform an electrical test of the chain-link converter 52 under test, the current injection circuit 36 is initially operated to inject an overcurrent waveform into the chain-link converter 52 under test, in order to expose the chain-link converter 52 under test to test overcurrent conditions. Subsequently the chain-link converter 52 under test is controlled to form the plurality of series-connected diode rectifiers so as to provide the opposing voltage and thereby drive the overcurrent waveform to zero and to absorb any inductive energy stored in the inductance of the synthetic test circuit 30. Finally the current injection circuit 36 is operated to inject a sinusoidal voltage waveform into the chain-link converter 52 under test when the overcurrent waveform is inhibited from flowing in the chain-link converter 52 under test, in order to simulate DC fault current extinction with both polarities of an alternating driving voltage.

In addition, the AAC may be operated as a static synchronous compensator during occurrence of a DC fault.

Accordingly, during use of the synthetic test circuit 30 to perform an electrical test of the chain-link converter 52 under test, the current injection circuit 36 is initially operated to inject an overcurrent waveform into the chain-link converter 52 under test, in order to expose the chain-link converter 52 under test to test overcurrent conditions. Subsequently the chain-link converter 52 under test is controlled to form the plurality of series-connected diode rectifiers so as to provide the opposing voltage and thereby drive the overcurrent waveform to zero and to absorb any inductive energy stored in the inductance of the synthetic test circuit 30. Finally the current injection circuit 36 is operated to inject a first sinusoidal voltage waveform into the chain-link converter 52 under test, and the chain-link converter 52 under test is operated to generate a second sinusoidal voltage waveform thereacross, whereby the magnitudes of the in-phase first and second sinusoidal voltage waveforms are controlled to cause reactive power to circulate between the current injection circuit 36 and the chain-link converter 52 under test. This permits simulation of test current and voltage conditions corresponding to actual in-service current and voltage conditions experienced by a chain-link converter 52 when the AAC is operated as a static synchronous compensator during occurrence of a DC fault.

Other electrical tests may be performed on the chain-link converter 52 under test. In one such electrical test, the synthetic test circuit 30 may be operated to inject a voltage waveform including voltage ripple into the chain-link converter 52 under test. In another such electrical test, each module switch 54 of each test module may be switched at a peak, non-zero, zero or substantially zero value of a current waveform injected into the chain-link converter 52 under test and/or at a peak or non-zero value of a voltage waveform injected into the chain-link converter 52 under test, in order to test the soft and hard current switching capabilities and hard voltage switching capabilities of the module switches 54 of the test modules.

In view of the foregoing the provision of the chain-link converters 44 in the current and voltage injection circuits 36,40 and the provision of the chain-link converter 52 under test therefore results in a synthetic test circuit 30 that is not only capable of performing high quality electrical testing, but also has the flexibility to perform an electrical test on a broad range of chain-link converters 52 with different ratings. This is because the capability of each chain-link converter 44,52 to generate a voltage waveform thereacross using a stepwise approximation allows the current and voltage injection circuits 36,40 to inject current and voltage waveforms of varying levels into the chain-link converter 52 under test and allows the chain-link converter 52 under test to generate a wide range of voltage waveforms thereacross, and thus renders the synthetic test circuit 30 capable of electrically testing various chain-link converters 52 across a wide range of ratings.

In addition the modular arrangement of each chain-link converter 44,52 means that the number of modules in each chain-link converter 44,52 can be readily scaled up or down to modify the voltage capability of each chain-link converter 44,52 to match the testing requirements of the chain-link converter 52 under test, without having to make significant changes to the overall design of the synthetic test circuit 30.

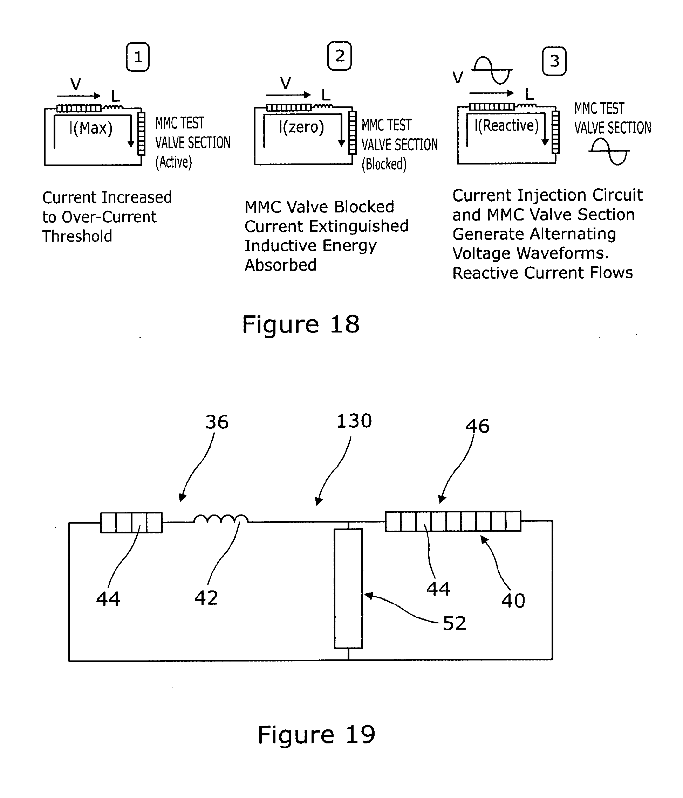

A synthetic test circuit according to a second embodiment of the invention is shown in Figure 19, and is designated generally by the reference numeral 130. The synthetic test circuit of Figure 19 is similar in structure and operation to the synthetic test circuit 30 of Figures 1 a and 1 b, and like features share the same reference numerals.

The synthetic test circuit 130 of Figure 19 differs from the synthetic test circuit 30 of Figures 1 a and 1 b in that the voltage rating of the source chain-link converter 44 of the current injection circuit 36 exceeds the voltage rating of the source chain-link converter 44 of the voltage injection circuit 40. This allows the current injection circuit 36 to be operated to selectively provide a blocking voltage to isolate the current injection circuit 36 from the voltage injection circuit 40 and chain-link converter 52 under test, thus obviating the need for the isolation switch 38.

In other embodiments of the invention, it is envisaged that the current injection circuit 36 may include a plurality of parallel-connected current sources. The number of parallel-connected current sources in the current injection circuit 36 may vary to adapt the current capability of the current injection circuit 36 for compatibility with the current rating and test current conditions of the chain-link converter 52 under test.

It will be appreciated that the above type of chain-link converter 52 and the above exemplary application of the chain-link converter 52 described in this specification are merely chosen to illustrate the working of the invention. Accordingly it will also be appreciated that the invention is intended to extend to the use of the synthetic test circuit 30,130 with other types of chain-link converters 52 that may be used in other types of power applications, which are not limited to the field of HVDC power transmission.

It will be also appreciated that the electrical tests and the shapes of the voltage and current waveforms described in this specification are merely chosen to illustrate the working of the invention. Accordingly it will also be appreciated that other electrical tests and other shapes of the voltage and current waveforms may be used with the synthetic test circuit 30,130 according to the invention.

## Claims

1. A synthetic test circuit, for performing an electrical test on a device under test, comprising:
a device under test including a chain-link converter under test, the chain-link converter under test including a test module or a plurality of test modules, the or each test module including at least one energy storage device;
a terminal connected to the device under test;
at least one injection circuit operably connected to the terminal, the or each injection circuit including a source, the source including a source chain-link converter, the source chain-link converter including a plurality of source modules, each source module including at least one energy storage device;
a controller being configured to operate each source module to selectively bypass the or each corresponding energy storage device and insert the or each corresponding energy storage device into the corresponding source chain-link converter so as to generate a voltage across the source chain-link converter and thereby operate the or each injection circuit to inject a current waveform and/or a voltage waveform into the chain-link converter under test.

2. A synthetic test circuit according to Claim 1 wherein the or at least one injection circuit is a current injection circuit, the current injection circuit including a current source, the current source including a source chain-link converter, the source chain-link converter including a plurality of source modules.

3. A synthetic test circuit according to any preceding claim wherein the or at least one injection circuit is a voltage injection circuit, the voltage injection circuit including a voltage source, the voltage source including a source chain-link converter, the source chain-link converter including a plurality of source modules.

4. A synthetic test circuit according to any preceding claim wherein the current waveform injected into the chain-link converter under test is selected from a group including:
• a part-sinusoidal or fully-sinusoidal current waveform;
• a harmonic modulated current waveform;
• a current waveform that includes one or more anti-phase current components, preferably a current waveform that includes one or more anti-phase harmonic or ripple components;
• a current waveform with a duty cycle of 180 or 240 electrical degrees;
• a bidirectional or unidirectional current waveform; or
• a combination thereof.

5. A synthetic test circuit according to any preceding claim wherein the voltage waveform injected into the chain-link converter under test is selected from a group including:
• a part-sinusoidal or fully-sinusoidal voltage waveform;
• a harmonic modulated voltage waveform, preferably a triplen harmonic modulated voltage waveform;
• a voltage waveform including voltage ripple;
• a voltage waveform with a duty cycle of 180 or 240 electrical degrees;
• a bidirectional or unidirectional voltage waveform; or
• a combination thereof.

6. A synthetic test circuit according to any preceding claim wherein the controller is configured to operate the or each injection circuit to inject the current waveform into the chain-link converter under test so as to control an energy level of the or each energy storage device of the or each test module and/or control the energy level of the chain-link converter under test to obtain a zero net change in energy level of the chain-link converter under test over an operating cycle.

7. A synthetic test circuit according to any preceding claim wherein the controller is configured to operate the or each test module to selectively bypass the or each corresponding energy storage device and insert the or each corresponding energy storage device into the chain-link converter under test so as to generate a voltage waveform across the chain-link converter under test during the injection of the current waveform and/or the voltage waveform into the chain-link converter under test.

8. A synthetic test circuit according to Claim 7 wherein the voltage waveform across the chain-link converter under test is selected from a group including:
• a part-sinusoidal or fully-sinusoidal voltage waveform;
• a harmonic modulated voltage waveform, preferably a triplen harmonic modulated voltage waveform;
• a voltage waveform including voltage ripple;
• a voltage waveform with a period of 180 or 240 electrical degrees;
• a bidirectional or unidirectional voltage waveform; or
• a combination thereof.

9. A synthetic test circuit according to Claim 7 or Claim 8 wherein the controller is configured to operate the or each test module to selectively bypass the or each corresponding energy storage device and insert the or each corresponding energy storage device into the chain-link converter under test so as to generate a voltage waveform across the chain-link converter under test during the injection of the current waveform and/or the voltage waveform into the chain-link converter under test so as to:
• combine the voltages across the or each source chain-link converter and the chain-link converter under test and thereby control the current waveform injected into the chain-link converter under test;
• control an energy level of the or each energy storage device of the or each test module;
• control the energy level of the chain-link converter under test to obtain a zero net change in energy level of the chain-link converter under test over an operating cycle;
• control the energy level of the chain-link converter under test to obtain a zero net change in energy level of the or each test module over an operating cycle;
• when the chain-link converter includes a plurality of test modules, equalise or substantially equalise the voltage levels of the plurality of test modules;
• control the current loading of the or each test module;
• when the chain-link converter includes a plurality of test modules, equalise or substantially equalise the current loading of the plurality of test modules; and/or
• control the injected current waveform to be a leading current, a lagging current, or in-phase with the voltage waveform across the chain-link converter under test.

10. A synthetic test circuit according to any of Claims 7 to 9 wherein the or each test module includes at least one module switch, and the controller is configured to control switching of the or each module switch of the or each test module to selectively bypass the or each corresponding energy storage device and insert the or each corresponding energy storage device into the chain-link converter under test so as to generate a voltage waveform across the chain-link converter under test.

11. A synthetic test circuit according to Claim 10 wherein the controller is configured to control switching of the or each module switch of the or each test module so as to switch at a peak, non-zero, zero or substantially zero value of the current waveform injected into the chain-link converter under test and/or at a peak or non-zero value of the voltage waveform injected into the chain-link converter under test.

12. A synthetic test circuit according to Claim 10 or Claim 11 wherein the controller is configured to control switching of the or each module switch of the or each test module so as to block current from flowing in the or each test module and thereby inhibit current from flowing in the chain-link converter under test.

13. A synthetic test circuit according to Claim 12 wherein the or each module switch of the or each test module includes an active switching device connected in parallel with an anti-parallel passive current check element, and the controller is configured to turn off the or each active switching device of the or each test module to allow the anti-parallel passive current check elements to form a plurality of series-connected passive current check element rectifiers with a combined internal voltage that is greater than a voltage waveform across the chain-link converter under test so as to block current from flowing in the or each test module and thereby inhibit current from flowing in the chain-link converter under test, wherein the combined internal voltage is provided by the or each energy storage device of the or each test module.

14. A synthetic test circuit according to Claim 12 or Claim 13 wherein the controller is configured to operate the or each injection circuit to inject a voltage waveform into the chain-link converter under test when the chain-link converter under test is controlled to inhibit current from flowing in the chain-link converter under test.

15. A synthetic test circuit according to any of Claims 12 to 14 wherein the controller is configured to operate the or each injection circuit to inject an overcurrent waveform into the chain-link converter under test and to control the chain-link converter under test to inhibit the overcurrent waveform from flowing in the chain-link converter under test.

16. A synthetic test circuit according to Claim 15 wherein the controller is configured to operate the or each injection circuit to inject an alternating voltage waveform into the chain-link converter under test when the overcurrent waveform is inhibited from flowing in the chain-link converter under test.

17. A synthetic test circuit according to Claim 15 wherein the controller is configured to operate the or each injection circuit to:
• inject a first alternating voltage waveform into the chain-link converter under test; and
• operate the or each test module to selectively bypass the or each corresponding energy storage device and insert the or each corresponding energy storage device into the chain-link converter under test so as to generate a second alternating voltage waveform across the chain-link converter under test,
subsequent to the overcurrent waveform being inhibited from flowing in the chain-link converter under test.

18. A synthetic test circuit according to Claim 17 wherein the first and second alternating voltage waveforms are controlled to cause reactive power to circulate between the or each injection circuit and the chain-link converter under test.
